Europäisches Patentamt

European Patent Office

Office européen des brevets

(11) Publication number: **0 336 396**
**A2**

## EUROPEAN PATENT APPLICATION

(21) Application number: 89105975.0

(22) Date of filing: 05.04.89

(51) Int. Cl.⁴: **H03K 19/013 , H03K 19/086**

(30) Priority: 08.04.88 JP 86608/88

(43) Date of publication of application:
**11.10.89 Bulletin 89/41**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Fujita, Katsuji c/o Patent Division**
**K.K. TOSHIBA**
**1-1 Shibaura 1-chome**
**Minato-ku Tokyo 105(JP)**

(74) Representative: **Henkel, Feiler, Hänzel &**
**Partner**
**Möhlstrasse 37**
**D-8000 München 80(DE)**

(54) **Non-saturation type logic circuit.**

(57) The present invention discloses a non-saturation type logic circuit including a logic circuit section (10) comprising a plurality of input transistors (13, 14) of a first polarity having their emitters commonly connected to a first current source (16) and their bases connected to receive their corresponding input signals and a first transistor (15) of the first polarity having its emitter connected to the first current source (16) and its base connected to be supplied with a reference voltage, an output circuit (30) second and third transistors (31, 32) of the first polarity having their bases commonly connected to the collector of the first transistor (15) in the logic circuit section and supplied with an output signal from the logic circuit section (10), a second current source (34) connected to the emitter of the second transistor (31), and a fourth transistor (35) of a second polarity having its emitter connected to the third transistor (32) and its base connected to the emitter of the second transistor (31) in which, when the second and third transistors (31, 32) are turned OFF, the fourth transistor (35) is turned ON due to electric current supplied from the second current source (34), and a load capacitor (20) which is charged by electric current from the third transistors (32) and discharged to gound through the fourth transistor (35).

Vin

Vout

EP 0 336 396 A2

## F I G. 4

## Non-saturation type logic circuit

The present invention relates to a non-saturation type logic circuit which can drive a large-capacity load at high speed with the use of an improved output section.

A non-saturation type logic circuit, such as an ECL (emitter coupled logic) and CML (current mode logic or common mode logic) has the advantage of being able to implement a high-speed operation in comparison with a saturation type logic circuit, such as a TTL (transistor-transistor logic). However, even the non-saturation type logic circuit, such as a gate array and ultra LSI, which has a very great load capacity, becomes pronounced in a delay of an output, lowering an operation speed.

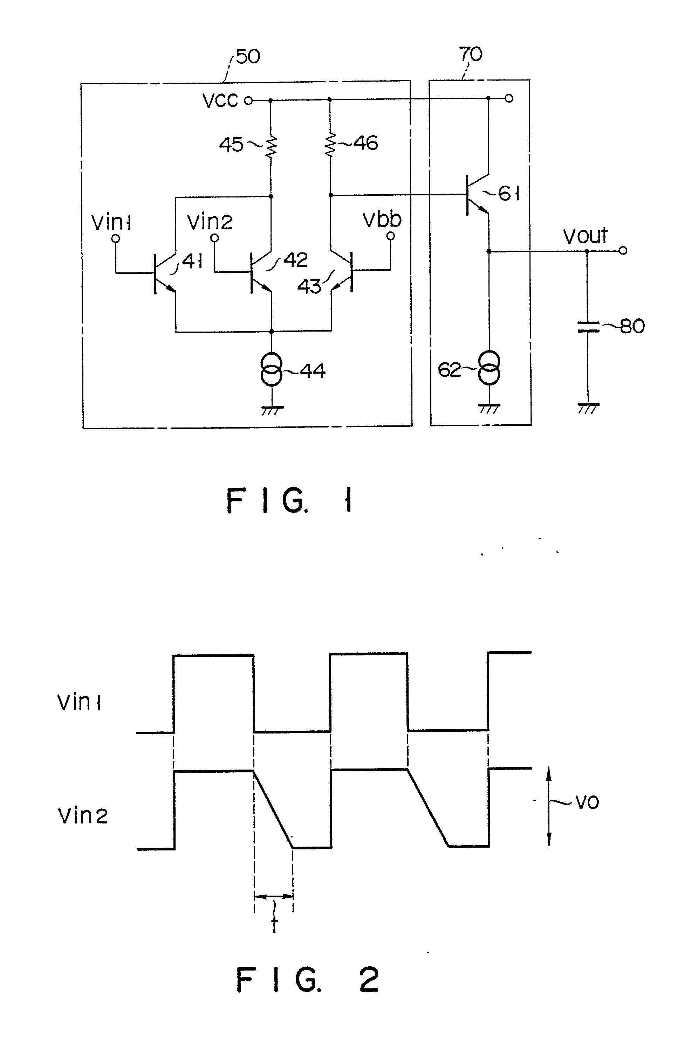

Fig. 1 is a circuit diagram showing a conventional ECL type logic circuit, one type of a non-saturation type logic circuit. The logic circuit comprises a two-input logic section 50 and an emitter follower type output section 70. The logic circuit section 20 comprises npn transistors 41 and 42 whose bases are supplied with inputs Vin1 and Vin2, respectively, an npn transistor 43 having its base supplied with a predetermined bias voltage Vbb, a constant current source 44 connected to the emitters of the transistors 41, 42 and 43, and load resistors 45 and 46.

The output section 70 comprises an npn transistor 61 and a constant current source 62 connected to the emitter of a transistor 61, providing an emitter follower configuration. The output section 70 drives a load capacitor 80 upon receipt of an output of the logic section 50.

If, in the non-saturation logic circuit, the input signals Vin1 and Vin2 both go low, the transistor 61 of the output circuit section 70 is turned OFF and the load capacitor 80 is discharged to ground through the constant current source 62 of the output circuit section 70.

Here let it be assumed that a pulse-like signal as shown in a timing chart of FIG. 2 is supplied as an input signal Vin1 to the logic section 50. When the signal Vin1 goes from a low level to a high level, the transistor 61 is turned ON. As a result, the load capacitor 80 is rapidly charged by the collector current of the tranistor 80 and a voltage Vout across the load capacitor 80 rapidly rises. On the other hand, when the signal Vin1 varies from a high level to a low level, the load capacitor 80 is discharged to ground by the constant current source 62 in the output circuit section 70. At the time of such a discharge, if the level of the load capacitor 80 is great, the voltage Vout falls slowly, producing a delay of a time t to the fall of the signal Vin1. The time t is given by:

$$ t = \frac{V_O \cdot C_S}{i_O} \qquad \ldots (1) $$

where

$V_O$: the amplitude of a voltage across the load capacitor;

$C_S$: the level of the load capacitor 80; and

$i_O$: the current level of the constant level source 62.

In the circuit arrangement shown in Fig. 1, in order to reduce the delay time t of Equation (1) and hence to perform a high-speed operation, it is necessary to, for example, reduce the amplitude $V_O$, reduce the capacitive level $C_S$ of the load capacitor 80, and increase the current level $i_O$ of the constant current source 62. However, there is a restriction on an increase in the capacitive level of the load capacitor 80 because of that greater capacitive level of the load capacitor 80. There is also a restriction on the capacitive level $C_S$ of the load capacitor 80 because it is inevitably increased if the non-saturation type logic circuit, such as an ECL and CML, is applied to, for example, gate arrays and ultra LSIs.

The best way for decreasing a delay time is to increase the current level $i_O$ of the constant current source 62, a method which has usually been practiced. Since, however, a constant current normally flows through the constant current source 62 in spite of the state of an input signal, a constant power is usually dissipated. An increase in the current level of the constant current source 62 would lead to a steady increase in the dissipation power. Furthermore, an amount of heat which is produced in the ECL type logic circuit is increased with an increasing dissipation power and the junction temperature of the elements in the circuit arrangement is increased. For this reason, the current level of the constant current source 62 is suppressed to a given extent.

It is accordingly the object of the present invention to provide a non-saturation type logic circuit which can achieve a high-speed operation without involving an steady increase in dissipation power, which would otherwise been encountered in a conventional non-saturation type logic circuit, such as ECLs and CMLs.

According to the present invention, there is provided a non-saturation type logic circuit which com-

2

prises:

a logic circuit section comprising a plurality of input transistors of a first polarity having their emitters commonly connected to a first current source and their bases connected to receive their corresponding input signals and a first transistor of the first polarity having its emitter connected to the first current source and its base connected to be supplied with a reference voltage;

an output circuit comprising second and third transistors of the first polarity having their bases commonly connected to the collector of the first transistor in the logic circuit section and supplied with an output signal from the logic circuit section, a second current source connected to the emitter of the second transistor, and a fourth transistor of a second polarity having its emitter connected to the third transistor and its base connected to the emitter of the second transistor in which, when the second and third transistors are turned OFF, the fourth transistor is turned ON due to electric current supplied from the second current source; and

a load capacitor which is charged by electric current from the third transistor and discharged to ground through the fourth transistor.

According to the present invention, the load capacitor is charged with a charging current of the second transistor and discharged through the third transistor.

Even if electric current which is supplied from the second current source to the third transistor is smaller in level, the load capacitor is discharged with electric current which is larger by a current amplification factor of the third transistor.

This invention can be more fully understood from the following detailed description when taken in conjunction with the accompanying drawings, in which:

Fig. 1 is a circuit diagram showing a conventional non-saturation type logic circuit;

Fig. 2 is an operation waveform chart showing a circuit diagram shown in Fig. 1;

Fig. 3 is a circuit diagram showing a non-saturation type logic circuit according to an embodiment of the present invention;

Fig. 4 is an operation waveform chart showing a circuit diagram shown in in Fig. 3; and

Figs. 5 to 7 are diodes as each used in the circuit shown in Fig. 3.

One embodiment of the present invention will be explained below in more detail.

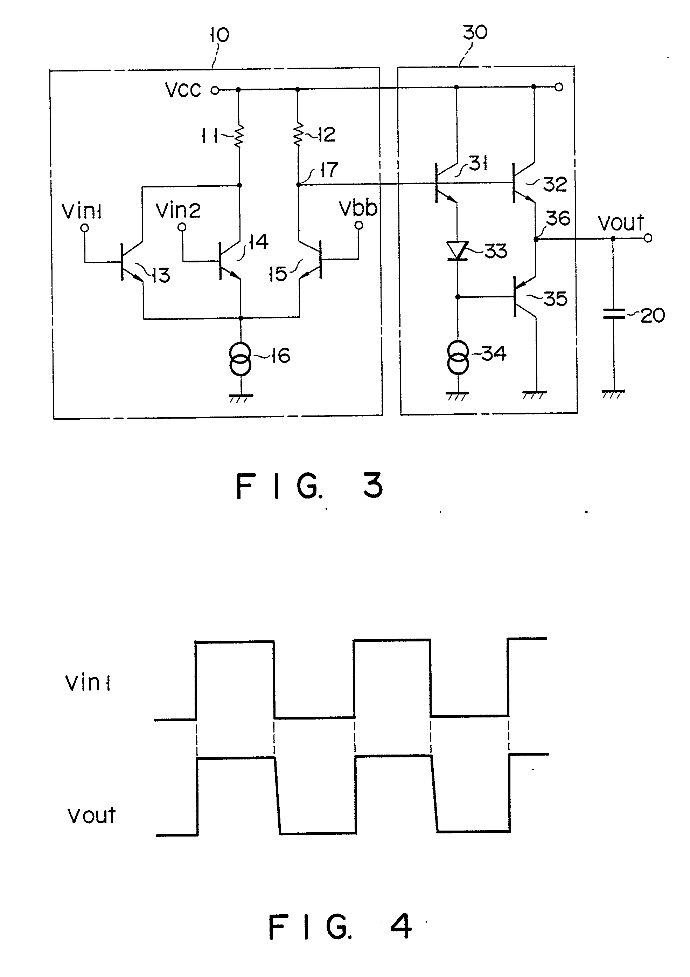

Fig. 3 is a circuit arrangement showing a non-saturation type logic circuit of the present invention which is applied to an ECL type logic circuit. The logic circuit comprises a logic circuit section 10 and an output circuit section 30 for driving a load capacitor 20 in accordance with an output of the logic circuit section 10.

The logic circuit section 10 comprises resistors 11 and 12, npn transistors 13 and 14 supplied at their bases with input signals Vin1 and Vin2, respectively, an npn transistor 15 supplied at its base with a bias voltage Vbb of a predetermined level lower than a maximum level of the input signals Vin1 and Vin2, and a constant current source 16. The resistors 11 and 12 are connected at one terminal to a power supply potential Vcc. The collectors of the transistors 13 and 14 are connected to the other terminal of the resistor 11. The collector of the transistor 15 is connected to the other terminal of the resistor 12. The emitters of the transistors 13, 14 and 15 are connected via their common junction to a constant current source 16 which is in turn is connected to ground. An output signal of the logic circuit section is fed to the output circuit section 30 from a junction 17 of the resistor 12 and transistor 15.

The output circuit section 30 comprises npn transistors 31 and 32, a diode formed of, for example, a junction diode, a constant current source 34 and a pnp transistor 35. The bases of npn transistors 31 and 32 are commonly connected to the junction 17 of the resistor 12 and collector of the transistor 15 in the logic circuit section 10. The collectors of the transistors 31 and 32 are both connected to the power supply potential Vcc. The anode of the diode 33 is connected to the emitter of the transistor 31 and the cathode of the diode 33 is connected to one terminal, that is, the diode 33 side, of a constant current source 34. The other terminal of the constant current source 34 is connected to ground. The emitter of a transistor 35 is connected to that of the transistor 32. The base of the transistor 35 is connected to one terminal, that is, the diode 33 side, of the constant current source 34. The collector of the transistor 35 is connected to ground. A common junction of the transistors 32 and 35 is connected to a circuit point 36 from which an output signal Vout is taken. A load capacitor 20 is connected to the circuit point 36. That is, the output section 30 comprises an emitter follower circuit comprising of the npn transistor 31, diode 33 and constant current source 34 and a push-pull output circuit comprising the npn transistor 32 which is driven with an output signal from the circuit point 17 of the logic circuit section 10 and pnp transistor 35 which is driven with an output signal of the emitter follower circuit.

The operation of the circuit arrangement will be explained below with reference to Fig. 4.

Now let it be assumed that the input signals Vin1 and Vin2 which are supplied to the bases of the transistors 13 and 14 in the logic circuit 10 vary from a high level to a low level. In this case, the transistors

3

13 and 14 are turned OFF and the transistor 15 is turned ON. Thus the transistors 31 and 32 in the output circuit section 30 are both turned OFF. The current of the constant current source 34 flows across the base of the pnp transistor 35, turned the transistor 35 ON and the load capacitor 20 is dischasrged to ground.

When either one of the input signals Vin1 and Vin2 goes high, the transistors 31 and 32 in the output circuit section 30 are both turned ON and the transistor 35 is turned OFF. At this time, the base potential of the pnp transistor 35 goes high due to electric current flowing across the npn transistor 31 and diode 33. For this reason, the transistor 35 is rendered conductive. On the other hand, the load capacitor 20 is charged via that conducting transistor 32.

Now let it be assumed that a pulse-like signal as shown in a timing chart in Fig. 4 is supplied as an input signal Vin1. By a greater collector current of the transistor 32 which is turned ON when the signal Vin1 varies from a low level to a high level, the load capacitor 20 is quickly charged and hence the voltage Vout across the load capacitor 20 rises quickly. ON the other hand, when a signal Vin1 varies from a high level to a low level, the transistors 31 and 32 are both turned OFF and the load capacitor 20 is discharged to ground via the transistor 35. At this time, the load capacitor 20 is discharged with a larger current which is obtained by amplifying the electric current of the constant current source 34 by the pnp transistor 35. Therefore, the terminal voltage Vout of the load capacitor 20 rapidly rises in the case of the aforementioned rise time. The current level $i_{OS}$ of the constant current source 34 is given below:

$$i_{OS} = \frac{i_O}{1 + \beta(pnp)} \qquad \ldots (2)$$

where
$i_{OS}$: the emitter current of the pnp transistor 35
$\beta(pnp)$: a base current amplification factor of the pnp transistor 35.

That is, even if the load capacitor 20 is discharged as an adequately great current through the transistor 35, the current level $i_{OS}$ of the constant current source 34 itself can be made smaller than the emitter current of the pnp transistor 35 as indicated by Equation (2).

For this reason, the electric current which is normally flowed in the constant current source 34 can be reduced below a conventional level in the embodiment shown in Fig. 3, making it possible to reduce a normal dissipation power. It is possible to suppress and increase in an amount of heat of the element by so doing. As a result, a package for holding a chip can be made of an inexpensive plastic, thus reducing a manufacturing cost.

Furthermore, since the load capacitor 20 is discharged with an adequately great current through the transistor 35, a delay time of an output signal to an input signal is reduced to achieve a high-speed operation.

The diode 33 in the output circuit section 20 is provided such that, when the load capacitor 20 is charged, the maximum output voltage of the voltages Vout across the load capacitor 20 is raised substantially up to the power supply potential Vcc. The diode 33 is provided so that the non-saturation type logic circuit of the present invention may be implemented at an ECL logic amplitude (usually at an amplitude of 200 to 300 mV peak-to-peak).

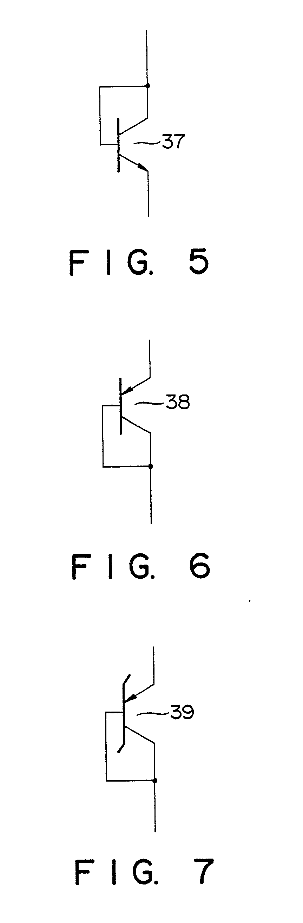

Various changes and modification of the present invention may be made without being restricted to the aforementioned embodiment. Although, in the embodiment shown in Fig. 3, the diode 33 has been explained as being a pn junction diode, it may be replaced instead by, for example, an npn transistor 37 whose base-to-collector circuit is shorted as shown in Fig. 5, a pnp transistor 38 whose base-to-collector circuit is shorted as shown in Fig. 6, a Schottky type pnp transistor 39, or a Schottky type diode whose base-to-collector circuit is shorted.

## Claims

1. A non-saturation type logic circuit comprising:
a logic circuit section (10) comprising a plurality of input transistors (13, 14) of a first polarity having their emitter commonly connected to a first current source (16) and their bases connected to receive their corresponding input signals and a first transistor (15) of the first polarity having its emitter connected to the first current source (16) and its base connected to be supplied with a reference voltage;
an output circuit (30) comprising second and third transistors (31, 32) of the first polarity having their bases commonly connected to the collector of the first transistor (15) in the logic circuit section and supplied with an output signal from the logic circuit section (10), a second current source (34) connected to the emitter of the second transistor (31), and a fourth transistor (35) of a second polarity having its emitter connected to the third transistor (32) and its base connected to the emitter of the second transistor (31) in which, when the second and third transistors (31, 32) are turned OFF, the fourth transistor (35) is turned ON due to electric current supplied from the second current source (34); and

a load capacitor (20) which is charged by electric current from the third transistor (32) and discharged to ground through the fourth transistor (35).

2. The non-saturation type logic circuit according to claim 1, characterized in that a diode (33) is connected between the emitter of said second transistor (31) and said second electric current source (34).

3. The non-saturation type logic circuit according to claim 2, characterized in that said diode (33) is a pn junction diode.

4. The non-saturation type logic circuit according to claim 2, characterized in that said diode (33) is an npn transistor which is shorted between its base and its collector.

5. The non-saturation type logic circuit according to claim 2, characterized in that said diode (33) is a pnp transistor which is shorted between its base and its collector.

6. The non-saturation type logic circuit according to claim 2, characterized in that said diode (33) is a Schottky type pnp transistor which is shorted between its base and its collector.

7. The non-saturation type logic circuit according to claim 2, characterized in that said diode (33) is a Schottky type diode which is shorted with its base and its collector.

F I G. 1

F I G. 2

F I G. 3

F I G. 4

F I G. 5

F I G. 6

F I G. 7